# EUROPEAN PATENT APPLICATION

(11) **EP 4 455 783 A1**
(43) Date of publication of application: **30.10.2024**
(21) Application number: 23169511.5
(22) Date of filing: 24.04.2023
(51) Int. Cl.: G03F 7/00

(54) **VACUUM SYSTEM**

(71) Applicant: ASML Netherlands B.V., 5500 AH Veldhoven (NL)
(72) Inventor: DE HOOGH, Joost, 5500 AH Veldhoven (NL); NAKIBOGLU, Günes, 5500 AH Veldhoven (NL); JACOBS, Johannes, Henricus, Wilhelmus, 5500 AH Veldhoven (NL); MCGRAW, Aaron, 5500 AH Veldhoven (NL); DIRECKS, Daniel, Jozef, Maria, 5500 AH Veldhoven (NL)
(74) Representative: ASML Netherlands B.V.

(57) **Abstract**

A vacuum system configured to provide a vacuum to a heat transfer fluid of a fluid-conditioned lithographic system element, the vacuum system comprising: a venturi, configured to generate a partial vacuum; and a buffer vessel, configured to contain a partial vacuum. The buffer vessel is in fluid communication with a constriction of the venturi, and the buffer vessel is further configured to be in fluid communication with a heat transfer fluid of a fluid-conditioned lithographic system element.

## Description

### FIELD

The present invention relates to a vacuum system. The vacuum system may provide a vacuum to a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

EUV radiation incident on surfaces such as optics, substrates and patterning devices, generates significant heat on and adjacent to such surfaces. Excessive heat generation can negatively impact the functionality of components of a lithographic apparatus.

Alternatively, some other optics, substrates and patterning devices may require an elevated temperature and/or additional heating.

The effects of the above-described heat generation can be mitigated by providing adjacent heat exchange or temperature-conditioning systems. A requirement for an elevated temperature can also be satisfied by adjacent heat exchange or temperature-conditioning systems. In particular, some components or elements of the lithographic apparatus may be provided with fluid-cooling, or more generally, fluid-conditioning systems. In an example, one or more optical mirrors, referred to as water-cooled mirrors (WCM), within the lithographic apparatus may be provided with a water-cooling system. Other components may be provided with a fluid-heating system.

In general, the interior of an EUV lithographic apparatus is under a relative vacuum, well below atmospheric pressure. Fluid -conditioned elements may be subject to a pressure differential between a heat transfer fluid of the cooling system and the lithographic apparatus interior. In some cases, a high-pressure differential between the lithographic apparatus interior and the heat transfer fluid may impose unacceptable mechanical stresses on the fluid-conditioned element. For example, distortions or even breakages can occur under a sufficient pressure differential.

In an example, the one or more WCMs of some lithographic apparatus may require a water-cooling system at a pressure less than 0.3bara.

It is therefore desirable to provide a vacuum source or system to reach a required pressure for fluid-conditioning systems of fluid-conditioned (i.e. fluid-cooled or fluid-heated) lithographic system elements.

Many vacuum systems are available for use. However, these may suffer from sensitivity to water damage, insufficiently low pressure and/or a large footprint. For example, a water ring pump can achieve the required low or reduced pressure, but would require a large dedicated area to accommodate it.

It may be desirable to address a problem associated with the prior art in a manner which is not disclosed or suggested by the prior art.

### SUMMARY

According to a first aspect there is provided a vacuum system configured to provide a vacuum to a heat transfer fluid of a fluid-conditioned lithographic system element, the vacuum system comprising: a venturi, configured to generate a partial vacuum; and a buffer vessel, configured to contain a partial vacuum; wherein the buffer vessel is in fluid communication with a constriction of the venturi, and wherein the buffer vessel is further configured to be in fluid communication with a heat transfer fluid of a fluid-conditioned lithographic system element.

The term fluid-conditioned should be interpreted to comprise both fluid-cooling and fluid-heating. In general, it should be interpreted to mean any form of fluid-based temperature conditioning.

Advantageously, the use of a venturi allows the vacuum system according to a first aspect to achieve a required reduced pressure or partial vacuum whilst being, small, simple and reliable. The vacuum system provided according to the first aspect also tolerates water and/or water vapour.

The vacuum system may further comprise a pressure control system comprising: a pressure sensor, in fluid communication with the buffer vessel; a control valve, configured to modify an outflow from the buffer vessel to the venturi; and a controller, configured to receive pressure data from the pressure sensor and actuate the control valve; wherein the controller is configured to actuate the control valve in response to pressure as sensed by the pressure sensor to maintain a selected pressure inside the buffer vessel.

The term controller should be interpreted as meaning any device of a wholly or partially mechanical, pneumatic, hydraulic or electrical nature configured to generate an output directed to reduce pressure variations. For example, the controller may form part of a pneumatic pressure switch.

The controller may be a bang-bang controller.

The controller may have a hysteresis configured to provide a duty cycle of up to around 10 % during normal operation.

The term normal operation should be interpreted as operation outside of start-up and shut-down of the vacuum system.

Advantageously, the bang-bang control scheme of the controller, reduces the energy consumption of the vacuum system, and can reduce the acoustic noise produced by the system, particularly during substrate exposure.

The controller may be configured to selectively operate when substrate is not being exposed.

The selected pressure may be around 0.15bara.

The fluid-conditioned lithographic system element may be a fluid-cooled lithographic system element.

The venturi working fluid may be a gas.

The working fluid gas may be air, nitrogen or mixtures thereof. The gas may be at a pressure of at least 2 bara. The gas may be at a pressure of at most 7.5 bara. The gas flowrate through the venturi may be around 100L/min.

The gas flowrate through the venturi may be at least 50 litres per minute. Gas flowrate through the venturi may be at most 150 litres per minute.

The pressure at the constriction of the venturi may be preferably at least 0.15bara. The pressure at the venturi constriction may be preferably at most 0.2bara.

A check valve may be provided between the buffer vessel and the venturi, the check valve being configured to restrict flow into the buffer vessel.

The check valve may be provided at the venturi outlet, the check valve being configured to prevent backflow.

The buffer vessel may have an internal volume up to around 5 litres.

The vacuum system of any preceding claim wherein the buffer vessel has an internal volume at least around 1 litre.

The vacuum system may further comprise a detachable water reservoir with a level sensor.

The vacuum system may further comprise a purge line.

The purge line may be further provided with a restriction (e.g. a valve or orifice plate) to moderate the flow of gas into the buffer vessel.

According to a second aspect there is provided a fluid-conditioned lithographic system element comprising a vacuum system of the first aspect. The vacuum system may comprise any of the optional features described above

The fluid conditioned lithographic system element may be a liquid-conditioned mirror.

According to a third aspect there is provided a lithographic apparatus comprising a fluid-conditioned lithographic system element of the first aspect. The fluid-conditioned lithographic system element may comprise any of the optional features described above

According to a fourth aspect there is provided a method of providing a vacuum to a heat transfer fluid of a fluid-conditioned lithographic system element, the method comprising:
providing a venturi, configured to generate a partial vacuum; and
providing a buffer vessel, configured to contain a partial vacuum;
wherein the buffer vessel is in fluid communication with a constriction of the venturi, and wherein the buffer vessel is further configured to be in fluid communication with a heat transfer fluid of a fluid-conditioned lithographic system element.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source, and further comprising a vacuum system according to an embodiment of the present disclosure;
- Figure 2 schematically depicts a simplified water-cooling circuit, comprising a vacuum system according to an embodiment of the present disclosure.
- Figure 3 schematically depicts a vacuum system according to an embodiment of the present disclosure.
- Figure 4 depicts a venturi of the embodiment of the vacuum system of Figure 3.
- Figure 5 schematically depicts a vacuum system according to another embodiment of the present disclosure.

### DETAILED DESCRIPTION

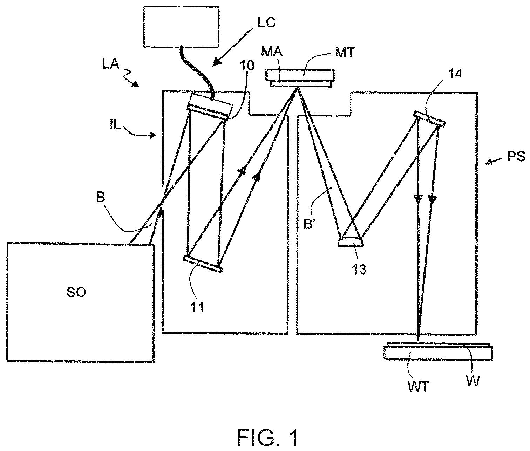

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

In some instances, one or more parts or elements of the lithographic apparatus LA may be provided with fluid-conditioning. The fluid-conditioning may be fluid-cooling or fluid-heating. Figure 1 shows a fluid-cooling system LC connected to facetted field mirror device 10. Other parts or elements of the lithographic apparatus may be connected to a fluid-cooling system according to an embodiment of the disclosure. For example, one or more other mirror devices (e.g. facetted pupil mirror device 11 etc.), the supporting structure MT for the patterning device and/or the substrate table WT may be connected to fluid-cooling systems. The supporting structure for the patterning device MT and substrate table WT may be known as the reticle stage and substrate stage, respectively.

In the following description, like parts will be referenced by like numerals. In addition, references to pipes, lines and/or connections should all be taken to mean enclosed conduits capable of containing a fluid flow from one location to another.

The fluid-cooling system LC may be a liquid-cooling system. The liquid-cooling system may be a water-cooling system.

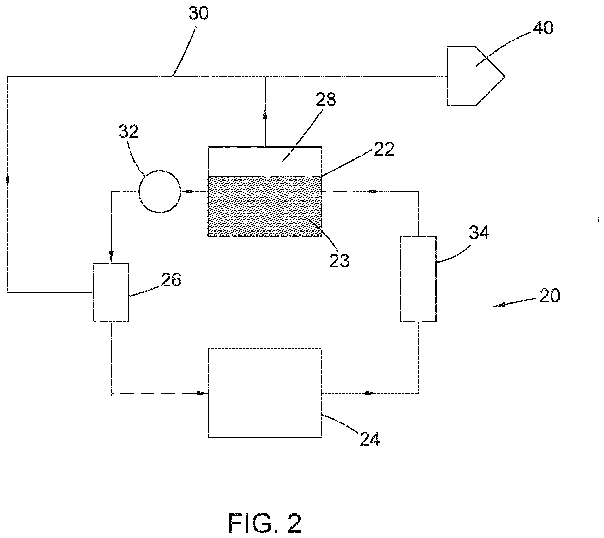

A fluid-conditioning system, liquid-cooling system 20, comprising a vacuum system is schematically illustrated in Figure 2. The liquid-cooling system 20 comprises a return tank 22, a water-cooled mirror 24, a degasser 26, pump 32, heat exchanger 34 and a vacuum system 40 according to an embodiment of the disclosure. The return tank 22, the pump 32, the degasser 26, water-cooled mirror 24 and heat exchanger 34 are connected via pipes or conduits in series within an overall circulation loop. The water-cooled mirror 24 may be referred to as the mirror for brevity. The loop is configured to convey a heat transfer liquid, in this case water, to and from the mirror 24 under pressure from pump 32. Both the return tank 22 and the degasser 26 are additionally connected to the vacuum system 40, via a common vacuum line 30. The mirror 24 is an example of a lithographic system element. In other embodiments, a different lithographic system element may be provided instead of the mirror 24 (e.g. a substrate table or patterning device support structure).

In use, water circulates from the return tank 28 to the degasser 26, where residual gases in the water are removed. The water then proceeds to, and exchanges heat with, the mirror 24. The (heated) water then enters the heat exchanger 34, in order to expel excess heat from the liquid-cooling system 20. The water subsequently returns to the return tank 22.

Heat exchanger 34 may be of various types well-known in the art. For example, heat exchanger 34 may be a liquid-liquid heat exchanger or one or more Peltier elements. In some embodiments heat exchange may be passive via heat sinks or without any dedicated heat exchange equipment.

In other embodiments, the arrangement of the liquid-cooling system components (e.g. pump 32) may vary. It will be appreciated, for example, that in liquid-cooling system 20, the order of the components around the loop is uncritical. In an alternative example, the pump 32 could be instead provided between the heat exchanger 34 and return tank 22.

Removal of residual gases from a cooling stream reduces the likelihood of bubble formation. Formation of bubbles is a source of undesirable vibration within the lithographic apparatus.

The return tank 22 contains a volume of water 23 and a headspace 28 at partial vacuum (i.e. under 1 atmosphere). The headspace may be at a pressure of around 0.3bara. As such the water pressure is obtained by an open bath system, being exposed to a headspace at partial vacuum. The water pressure may be maintained by an inline regulator (e.g. a controlled valve) along the vacuum line 30.

The degasser may be exposed to pressure lower than 0.3bara.

Figure 2 is not a comprehensive illustration of all apparatus within the liquid-cooling system 20. For example, the liquid-cooling system 20 may further comprise various valves, drain lines, sensors and controllers not shown in Figure 2.

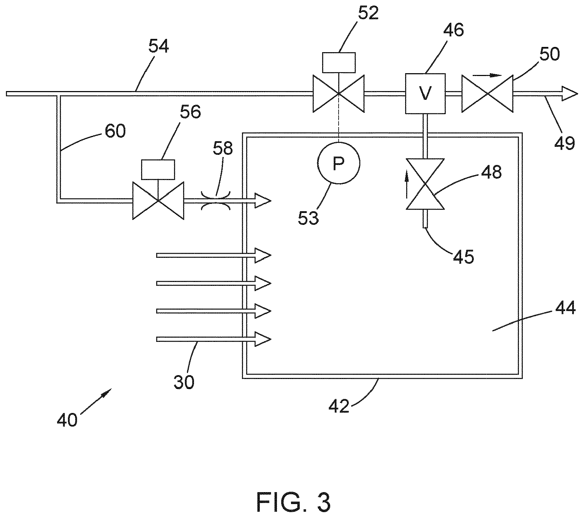

Figure 3 illustrates the vacuum system 40. The vacuum system 40 comprises a venturi 46 and a buffer vessel 42 which are in fluid communication with each other via an outlet pipe 45. The venturi 46 is configured to generate a partial vacuum at the outlet pipe 45. The buffer vessel 42 is configured to maintain an internal volume 44 at partial vacuum. The buffer vessel may have an internal volume of up to around 5 litres. The buffer vessel may have an internal volume of at least around 1 litre. The buffer vessel 42 is connected to one or more vacuum lines 30. The venturi 46 is connected to a clean dry air (CDA) line 54 and an exhaust line 49. CDA flows through the venturi 46, generating a partial vacuum. This results in a suction on the buffer vessel 42 through outlet pipe 45, thereby generating a partial vacuum within the buffer vessel 42.

The term partial vacuum refers to pressures greater than 0bara and less than atmospheric pressure (~1bara).

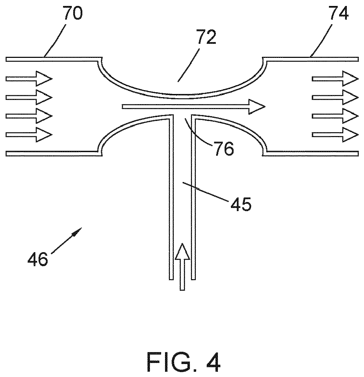

Figure 4 shows the venturi 46 in more detail. The venturi 46 comprises an inlet 70 which converges to a constriction 72. The constriction 72 diverges towards an outlet 74. In use, clean dry air from the CDA line 54 flows through the inlet 70 into the constriction 72. The CDA then exhausts via the outlet 74 into exhaust line 49 (see Figure 3). Because the cross section of the constriction 72 is smaller than the inlet 70 and outlet 74, mass-continuity means that gas velocity through the constriction 72 is higher than at the inlet 70 or the outlet 74. Increased local gas velocity decreases the local pressure, generating a partial vacuum at the constriction 72. Outlet pipe 45 is in fluid communication with the constriction 72 via a vacuum port 76.

In some embodiments the local pressure at the venturi constriction 72 may be at least 0.15bara. The local pressure at the venturi constriction 72 may be up to 0.2bara. Gas (e.g. CDA) flowrate through the venturi 46 may be around 100 litres per minute. Gas flowrate through the venturi 46 may be at least 50 litres per minute. Gas flowrate through the venturi 46 may be at most 150 litres per minute The pressure at the venturi inlet 70 may be at least around 2 bara. The pressure at the venturi inlet 70 may be up to around 7.5 bara. In an example, the pressure at the venturi inlet 70 may be 5bara.

Referring to Figures 2 to 4 in combination, the partial vacuum at constriction 72 generates a negative pressure gradient from the return tank headspace 28 and/or the degasser 26 through the buffer tank 42 to the constriction 72. The negative pressure gradient induces mass transport from the wider liquid-cooling system 20. The mass transported to the constriction 72 is ejected from the system via the exhaust line 49, maintaining the system vacuum.

The term mass transport refers to transport of a material of any kind. The material could comprise oxygen, nitrogen or water vapour.

The venturi 46 may be in non-continuous operation. Thus, the outlet pipe 45 and the exhaust line 49 are provided with buffer check valve 48 and exhaust check valve 50, respectively.

The buffer check valve 48 is configured to block all flow into the buffer vessel 42. In general, the clean dry air (CDA) in the clean dry air (CDA) line 54, venturi 46 and the exhaust line 49 are at a higher pressure relative to the buffer tank interior volume 44. Therefore, check valve 48 is used to reject uncontrolled flow of gas (namely CDA) into the buffer vessel 42.

The exhaust check valve 50 is configured to further prevent (reverse) flow through the exhaust line 49, toward the venturi 46. When the control valve 52 is closed, flow through the exhaust line to the venturi would, in the absence of check valve 50 and check valve 48, proceed into the buffer tank 42, raising the pressure of its interior volume 44. Both check valve 48 and check valve 50 prevent uncontrolled flow of CDA into the buffer vessel 42 and its connected components. This maintains the pressure of the interior volume 44 during periods where the venturi 46 is not operating. In some embodiments, only one check valve, check valve 48 may be provided. For example, in the embodiment discussed with reference to Figures 2-4, the exhaust check valve 50 could be deleted without significantly impairing the ability of the vacuum system 40 to reject uncontrolled flow of gas (e.g. CDA) into the buffer vessel 42.

It will be appreciated that during steady state operation of the liquid-cooling system 20 (i.e. outside of start-up and/or shut-down) gas is generated at very low rate. During steady-state operation, the liquid-cooling system 20 is largely closed with limited sources of gas ingress. Therefore, continuous operation of the vacuum system 40 may be unnecessary at steady state as very small amounts of gas needing removal are generated in relation to the volume of the buffer tank 42. Over time, gradual gas generation will cause a rise in operating pressure of the vacuum above an acceptable level. Periodic intervention to restore the selected pressure of the liquid-cooling system 20 may be desirable.

The vacuum system 40 further comprises a pressure control system comprising a control valve 52 and a pressure sensor 53. The pressure sensor 53 is in fluid communication with the buffer vessel internal volume 44 so as to provide an output indicative of the pressure in the buffer vessel internal volume. The control valve is provided in-line with the venturi inlet 70, so as to selectively admit and restrict CDA flow by opening and closing, respectively. The control valve 52 may have an integral controller configured to actuate the control valve 52 open in response to received pressure data to maintain a selected pressure inside the buffer vessel. The selected pressure may be at least around 0.1 bara. The selected pressure may be up to around 0.9 bara. The selected pressure may be preferably under 0.6 bara. In an example, the selected pressure may be 0.15bara.

The controller of the present embodiment operates under a 'bang-bang' control scheme. Namely, when the pressure in the buffer vessel interior 44 falls below a lower threshold, the control valve 52 is actuated to fully open. When the pressure in the buffer vessel interior reaches an upper threshold, the control valve is actuated to fully close. The upper and lower thresholds are selected to bracket the selected pressure, so as to achieve desired duty cycle (i.e. active operation percentage) behaviours, among other factors. In an example, the controller may be configured to have a duty cycle of less than 10% during normal operation.

Bang-bang control of the venturi control valve 52 for significant portions of operation is advantageous in that it reduces the average demand from vacuum system 40 for pressurised CDA relative to a continuous mode of operation. Reduced pressurised CDA demand reduces the energy consumption of vacuum system 40.

In addition, the controller may be configured to prevent venturi operation during substrate exposures, so as to reduce the impact of the acoustic noise of vacuum system 40 on substrate exposure.

It may be desirable to purge the buffer vessel 42 or vent the buffer vessel to ambient, for example during routine maintenance of the liquid-cooling system 20. As such, buffer vessel 42 is provided with another connection to CDA line 54: purge line 60. Purge line 60 is provided with an inline purge valve 56 which regulates the flow of CDA directly into the buffer vessel 42. CDA line 54 is at relatively high pressure (e.g. greater than 5bara). A restriction 58 is provided along the purge line 60 to restrict the flow rate of CDA entering the buffer vessel 42, so as to prevent excessively rapid repressurisation. Avoidance of excessively rapid repressurisation may be desirable so as to avoid excessive mechanical loads on the buffer vessel 42.

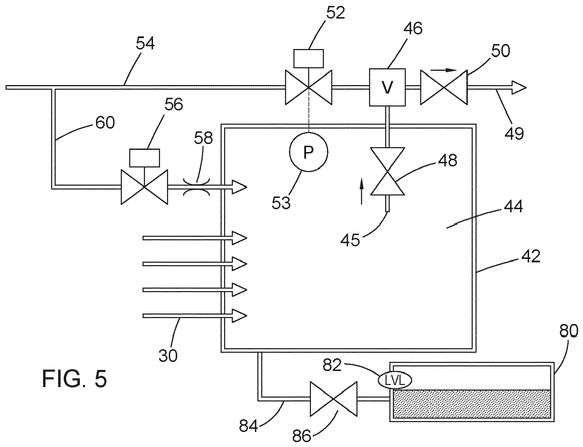

In some embodiments, water vapour may condense in the buffer vessel 42. Some accumulated liquid water in the buffer vessel 42 may be expelled via the venturi 46. However, significant quantities of condensed water in buffer vessel 42 may require active removal. Significant quantities of condensed water reduce the effective internal volume of the buffer tank 42, reducing the ability of vacuum system 40 to moderate fluctuations in system pressure without frequent operation of the venturi 46. An apparatus for active removal of condensed water in the buffer vessel 42 will now be described with reference to Figure 5.

Figure 5 shows an alternative embodiment in which a vacuum system is further provided with a detachable water reservoir 80. The detachable water reservoir 80 is detachably connected to the buffer vessel 42 via a drain line 84. Drain line 84 is provided with an automatic or manually-operable drain valve 86. In use, condensed water within the buffer vessel 42 can drain (e.g. under gravity or pump suction) to the detachable water reservoir 80. Over the course of operation, the level within the detachable water reservoir may rise. The detachable water reservoir 80 is further provided with a level sensor to indicate the internal level. It may be desirable to detach and empty the detachable water reservoir 80 periodically, as the detachable water reservoir fills.

In some embodiments, the role of CDA as a working fluid for the venturi, the degasser, and or buffer vessel purge components may also be fulfilled by other gases. For instance, nitrogen or another gas (e.g. any relatively inert gas) would also be a suitable working fluid in the above-described functions.

Whilst the above-described embodiments use water as their heat transfer fluid, other fluids could be used. For example, various oils or other synthetic hydrocarbons may be used as a heat transfer fluid in place of water.

Whilst a bang-bang pressure control scheme has been specified in the above-described embodiments, other control schemes may also be suitable. In an example, the pressure controller may be configured to operate under a proportional-integral-derivative scheme (PID), a proportional-integral scheme (PI) or a proportional scheme (P).

The above described embodiment provides a vacuum to a heat transfer liquid of a liquid-cooling system, which is an example of fluid-cooling system. Other embodiments may provide a vacuum to a heat transfer fluid of a fluid-heating system. In such a fluid-heating system, the heat transfer fluid (e.g. water or other liquid) acts to transfer heat (i.e. thermal energy) to a lithographic system element to control its temperature. Fluid-cooling and fluid-heating are both examples of fluid-conditioning.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A vacuum system configured to provide a vacuum to a heat transfer fluid of a fluid-conditioned lithographic system element, the vacuum system comprising:
a venturi, configured to generate a partial vacuum; and
a buffer vessel, configured to contain a partial vacuum;
wherein the buffer vessel is in fluid communication with a constriction of the venturi, and wherein the buffer vessel is further configured to be in fluid communication with a heat transfer fluid of a fluid-conditioned lithographic system element.

2. The vacuum system of claim 1, wherein the vacuum system further comprises a pressure control system comprising:
a pressure sensor, in fluid communication with the buffer vessel;
a control valve, configured to modify an outflow from the buffer vessel to the venturi; and
a controller, configured to receive pressure data from the pressure sensor and actuate the control valve; wherein the controller is configured to actuate the control valve in response to pressure as sensed by the pressure sensor to maintain a selected pressure inside the buffer vessel.

3. The vacuum system of claim 2, wherein the controller is a bang-bang controller.

4. The vacuum system of claim 3, wherein the controller has a hysteresis configured to provide a duty cycle of up to around 10% during normal operation.

5. The vacuum system of any of claims 2 to 4, wherein the selected pressure is around 0.15 bara.

6. The vacuum system of any preceding claim, wherein the fluid-conditioned lithographic system element is a fluid-cooled lithographic system element.

7. The vacuum system of any preceding claim, wherein the venturi working fluid is a gas.

8. The vacuum system of any preceding claim, wherein a check valve is provided between the buffer vessel and the venturi, the check valve being configured to restrict flow into the buffer vessel.

9. The vacuum system of any preceding claim wherein a check valve is provided at the venturi outlet, the check valve being configured to prevent backflow.

10. The vacuum system of any preceding claim, wherein the vacuum system further comprises a detachable water reservoir with a level sensor.

11. The vacuum system of any preceding claim, wherein the vacuum system further comprises a purge line.

12. A fluid-conditioned lithographic system element, comprising the vacuum system of any preceding claim.

13. The fluid-conditioned lithographic system element of claim 12, wherein the fluid conditioned lithographic system element is a liquid-conditioned mirror.

14. A lithographic apparatus comprising the fluid-conditioned lithographic system element of claim 12 or 13.

15. A method of providing a vacuum to a heat transfer fluid of a fluid-conditioned lithographic system element, the method comprising:
providing a venturi, configured to generate a partial vacuum; and
providing a buffer vessel, configured to contain a partial vacuum;
wherein the buffer vessel is in fluid communication with a constriction of the venturi, and wherein the buffer vessel is further configured to be in fluid communication with a heat transfer fluid of a fluid-conditioned lithographic system element.
